# EUROPÄISCHE PATENTANMELDUNG

(11) **EP 4 141 923 A1**
(43) Veröffentlichungstag der Anmeldung: **01.03.2023**
(21) Anmeldenummer: 22189020.5
(22) Anmeldetag: 05.08.2022
(51) Int. Cl.: H01L 23/373, H01L 23/31

(54) **LEISTUNGSHALBLEITERBAUTEIL UND VERFAHREN ZUR HERSTELLUNG EINES LEISTUNGSHALBLEITERBAUTEILS**

(30) Priorität: 27.08.2021 DE 102021209438
(71) Anmelder: Robert Bosch GmbH, 70442 Stuttgart (DE)
(72) Erfinder: Gera, Guenter, 71229 Leonberg (DE); Schiemenz, Kai, 70435 Stuttgart (DE)

(57) **Zusammenfassung**

Die Erfindung betrifft ein Leistungshalbleiterbauteil (10) für ein Hochleistungsmodul (1), mit einem AMB-Substrat (12), welches eine zwischen zwei Metallschichten (14) angeordnete Keramikschicht (13) umfasst, einem Halbleiterchip (16) und mindestens zwei Kontaktelementen (18), welche jeweils mit einem Anschluss (16.1, 16.2, 16.3) des Halbleiterchips (16) elektrisch verbunden sind, wobei ein dem AMB-Substrat (12) zugewandter erster Anschluss (16.1) des Halbleiterchips (16) über eine erste Sinterschicht (17A) mit einem vorgegebenen ersten Kontaktbereich (14.1) einer ersten Metallschicht (14A) der beiden Metallschichten (14) verbunden ist, wobei ein erstes Kontaktelement (18A) über eine zweite Sinterschicht (17B) mit einem zweiten Kontaktbereich (14.2) der ersten Metallschicht (14A) verbunden ist, welcher neben dem ersten Kontaktbereich (14.1) angeordnet und elektrisch mit dem ersten Kontaktbereich (14.1) verbunden ist, wobei mindestens ein von dem AMB-Substrat (12) abgewandter weiterer Anschluss (16.2, 16.3) des Halbleiterchips (16) über mindestens eine weitere Sinterschicht (17C, 17D) direkt mit mindestens einem weiteren Kontaktelement (18B, 18C) verbunden ist, wobei externe Kontaktflächen (18.1) der mindestens zwei Kontaktelemente (18) in einer gemeinsamen Ebene angeordnet und jeweils von oben in Richtung des AMB-Substrats (12) kontaktierbar sind, sowie ein Verfahren zur Herstellung eines solchen Leistungshalbleiterbauteils (10) und ein Hochleistungsmodul mit mindestens einem solchen Leistungshalbleiterbauteil (10).

## Beschreibung

Die Erfindung betrifft ein Leistungshalbleiterbauteil. Gegenstand der vorliegenden Erfindung sind auch ein korrespondierendes Verfahren zur Herstellung eines solchen Leistungshalbleiterbauteils sowie ein Hochleistungsmodul mit einem solchen Leistungshalbleiterbauteil.

Aus der DE 10 2016 212 381 A1 ist eine isolierende Sammelschiene bekannt, welche mit einem Hochleistungsmodul verbunden ist, auf dem ein Halbleiterchip montiert ist. Die Sammelschiene umfasst eine Vielzahl von Schaltungsleitern, eine Vielzahl von Anschlussklemmen, die jeweils die Schaltungsleiter mit dem Hochleistungsmodul elektrisch verbinden, und einen isolierenden Teil aus Harz, der zwischen jedem der Schaltungsleiter und mindestens einem Teil einer Region um jede Anschlussklemme herum einstückig gebildet ist und zwischen den Schaltungshalbleitern keine Lücken aufweist.

Aus der DE 10 2009 000 588 A1 ist ein Leistungshalbleitermodul mit einem Gehäuse bekannt. Das Gehäuse umfasst eine Schalung und mindestens eine Beschichtung mit hohem Widerstand gegenüber Oberflächenkriechwegbildung. An dem Gehäuse werden mehrere elektrische Leiter vorgesehen. Die Beschichtung wird auf einer Kriechstrecke vorgesehen, die zwischen den elektrischen Leitern vorgesehen ist.

### Offenbarung der Erfindung

Das Leistungshalbleiterbauteil mit den Merkmalen des unabhängigen Patentanspruchs 1 und das Hochleistungsmodul mit den Merkmalen des unabhängigen Patentanspruchs 9 haben jeweils den Vorteil, dass ein Halbleiterchip des Leistungshalbleiterbauteils im Vergleich mit einem Halbleiterchip eines herkömmlichen Leistungshalbleiterbauteils mit deutlich höheren Strömen belastet werden kann.

Ausführungsformen der vorliegenden Erfindung stellen ein Leistungshalbleiterbauteil für ein Hochleistungsmodul, mit einem AMB-Substrat (Active Metal Bracing), welches eine zwischen zwei Metallschichten angeordnete Keramikschicht umfasst, einem Halbleiterchip und mindestens zwei Kontaktelementen zur Verfügung, welche jeweils mit einem Anschluss des Halbleiterchips elektrisch verbunden sind. Hierbei ist ein dem AMB-Substrat zugewandter erster Anschluss des Halbleiterchips über eine erste Sinterschicht mit einem vorgegebenen ersten Kontaktbereich einer ersten Metallschicht der beiden Metallschichten verbunden. Ein erstes Kontaktelement ist über eine zweite Sinterschicht mit einem zweiten Kontaktbereich der ersten Metallschicht verbunden, welcher neben dem ersten Kontaktbereich angeordnet und elektrisch mit dem ersten Kontaktbereich verbunden ist. Mindestens ein von dem AMB-Substrat abgewandter weiterer Anschluss des Halbleiterchips ist über mindestens eine weitere Sinterschicht direkt mit mindestens einem weiteren Kontaktelement verbunden, wobei externe Kontaktflächen der mindestens zwei Kontaktelemente in einer gemeinsamen Ebene angeordnet und jeweils von oben in Richtung des AMB-Substrats kontaktierbar sind.

Des Weiteren wird ein Hochleistungsmodul mit mindestens einem solchen Leistungshalbleiterbauteil vorgeschlagen.

Zudem wird ein Verfahren zur Herstellung eines solchen Leistungshalbleiterbauteils vorgeschlagen. Das vorgeschlagene Verfahren umfasst die Schritte: Bereitstellen eines AMB-Substrats, bei welchem eine Keramikschicht flächig mit zwei Metallschichten verbunden ist, eines Halbleiterchips und von mindestens zwei Kontaktelementen. Verbinden des Halbleiterchips mit dem AMB-Substrat mittels eines ersten Sintervorgangs, so dass ein dem AMB-Substrat zugewandter erster Anschluss des Halbleiterchips über eine erste Sinterschicht mit einem vorgegebenen ersten Kontaktbereich einer ersten Metallschicht der beiden Metallschichten verbunden ist. Anordnen und Verbinden eines ersten Kontaktelements der mindestens zwei Kontaktelemente mit einem vorgegebenen zweiten Kontaktbereich der ersten Kupferschicht, welcher neben dem ersten Kontaktbereich angeordnet und elektrisch mit dem ersten Kontaktbereich verbunden ist, mittels eines zweiten Sintervorgangs, so dass das erste Kontaktelement über eine zweite Sinterschicht mit dem zweiten Kontaktbereich verbunden ist. Anordnen und Verbinden von mindestens einem weiteren Kontaktelement der mindestens zwei Kontaktelemente mit mindestens einem von dem AMB-Substrat abgewandten weiteren Anschluss des Halbleiterchips mittels mindestens eines weiteren Sintervorgangs, so dass der mindestens eine weitere Anschluss über mindestens eine weitere Sinterschicht direkt mit dem mindestens einen weiteren Kontaktelement verbunden ist. Hierbei werden die mindestens zwei Kontaktelemente so ausgeführt und angeordnet, dass externe Kontaktflächen der mindestens zwei Kontaktelemente in einer gemeinsamen Ebene angeordnet und jeweils von oben in Richtung des AMB-Substrats kontaktierbar sind.

Das eingesetzte AMB-Substrat, bei dem vorzugsweise eine Keramikschicht aus einer Si3N4-Kermaik zwischen zwei Metallschichten aus Kupfer angeordnet und mit diesen verbunden ist, weist eine sehr hohe thermische Leitfähigkeit bei gleichzeitiger elektrischer Isolation auf. Dadurch kann der Halbleiterchip des Leistungshalbleiterbauteils, welcher mit dem AMB-Substrat verbunden ist, im Vergleich mit einem Halbleiterchip, welcher mit einem herkömmlichen Leadframe verbunden ist, mit deutlich höheren Strömen belastet werden. Ein solches Leistungshalbleiterbauteil kann mit Ströme bis zu 300 Ampere belastet werden. Zudem können Hochspannungen von 460 Volt bzw. 850 Volt an das Leistungshalbleiterbauteil angelegt werden. Durch die Verwendung des AMB-Substrat kann eine elektrische Isolation von über 2.000 Volt erreicht werden. Um die thermische Leitfähigkeit und die thermomechanische Zuverlässigkeit des Leistungshalbleiterbauteils weiter zu erhöhen ist der Halbleiterchip nicht auf das AMB-Substrat gelötet, sondern über eine Sinterverbindung, vorzugsweise eine Silbersinterverbindung mit dem AMB-Substrat verbunden. Dadurch können für die thermische Leitfähigkeit Werte unter 0,5 Kelvin/Watt und für die thermische Kapazität Werte über 0,3 Joule/Kelvin erreicht werden. Durch die in einer gemeinsamen Ebene angeordneten externen Kontaktflächen der Kontaktelemente des Leistungshalbleiterbauteils und die damit verbundene in Richtung AMB-Substrat durchführbare Kontaktierung von oben, ist im Gegensatz zu gängigen seitlichen Kontaktierungen eine Anbindung des Halbleiterchips mit einer niedrigeren Induktivität möglich. Dadurch kann das Schaltverhalten des Halbleiterchips optimiert werden. Zudem kann durch die senkrechte Kontaktierung von oben eine sehr kleine Bauform realisiert werden.

Das Leistungshalbleiterbauteil kann beispielsweise als MOSFET-Bauteil ausgeführt sein. Hierbei können die Kontaktelemente vorzugsweise als Metall-Plättchen realisiert sein, welche mit den Anschlüssen des Halbleiterchips einen Gateanschluss, einen Sourceanschluss und einen Drainanschluss des als MOSFET-Bauteil ausgebildeten Leistungshalbleiterbauteils ausbilden. Ausführungsformen der Erfindung stellen ein miniaturisiertes diskretes Leistungshalbleiterbauteil zur Verfügung, das sich durch hervorragende thermische und elektrische Performance auszeichnet und für den Einsatz in einem Inverter von elektrischen Maschinen mittlerer Leistungsklasse geeignet ist, wie sie beispielsweise in Fahrzeugen mit elektrischem Antrieb zum Einsatz kommen. Auch eine Diode als Leistungshalbleiterbauteil ließe sich mit dieser Technologie ohne weiteres realisieren.

Durch die in den abhängigen Ansprüchen aufgeführten Maßnahmen und Weiterbildungen sind vorteilhafte Verbesserungen der im unabhängigen Patentanspruch 1 angegebenen Vorrichtung und des im unabhängigen Patentanspruch 10 angegebenen Verfahrens möglich.

Besonders vorteilhaft ist, dass eine zweite Metallschicht der beiden Metallschichten des AMB-Substrats eine externe thermische Kontaktfläche ausbilden kann, welche mit einem Kühlelement verbindbar ist. So kann das Kühlelement beispielsweise als Fluidkühler oder Kühlkörper ausgeführt sein. Hierbei kann das Leistungshalbleiterbauteil auf das Kühlelement aufgesetzt und mit diesem verbunden werden. Durch das AMB-Substrat kann eine elektrische Isolation von über 2.000 Volt von den Anschlüsse des Halbleiterchips zur thermischen Kontaktfläche umgesetzt werden.

In vorteilhafter Ausgestaltung des Leistungshalbleiterbauteils kann eine Umhüllung aus einem elektrisch isolierenden Material vorgesehen sein, welche das Leistungshalbleiterbauteil zumindest teilweise umhüllt. So kann die Umhüllung zumindest die externen Kontaktflächen der mindestens zwei Kontaktelemente und die externe thermische Kontaktfläche der zweiten Metallschicht des AMB-Substrats freilassen. Dadurch wird eine einfache Zugänglichkeit zur elektrischen und/oder thermischen Kontaktierung des Leistungshalbleiterbauteils ermöglicht. Gleichzeitig stellt die Umhüllung eine elektrische Isolation zwischen den einzelnen Anschlüssen des Halbleiterchips und den Kontaktelementen sicher.

In weiterer vorteilhafter Ausgestaltung des Leistungshalbleiterbauteils kann die Umhüllung eine überstehende Isolationsrippe umfassen, welche zwischen dem ersten Kontaktelement und dem mindestens einen weiteren Kontaktelement angeordnet ist und eine vorgegebene Höhe, eine vorgegebene Breite und einen vorgegebenen Überstand zu den mindestens zwei Kontaktelementen aufweist. Durch die Isolationsrippe können Luft- und Kriechstrecken von Signalen von benachbarten Kontaktelementen bzw. Anschlüssen bei gleichzeitig klein bleibendem lateralen und vertikalen Abstand ohne zusätzliche chemische Aufbau- und Verbindungstechnik signifikant erhöht werden. Dadurch kann die elektrische Isolation zwischen den Anschlüssen des Halbleiterchips und zwischen den einzelnen Kontaktelementen verbessert werden. Hierbei kann die Isolationsrippe eine beliebige Form aufweisen. So können beispielsweise Insolationsrippen mit dreieckigen oder runden oder trapezförmigen oder rechteckigen Querschnitten verwendet werden.

In weiterer vorteilhafter Ausgestaltung des Leistungshalbleiterbauteils können die externen Kontaktflächen der mindestens zwei Kontaktelemente so ausgeführt sein, dass die externen Kontaktflächen mittels eines Lötvorgangs oder mittels eines Sintervorgangs oder mittels eines Bondvorgangs kontaktierbar sind. Dies kann beispielsweise durch eine geeignete Beschichtung der externen Kontaktfläche umgesetzt werden. So können die externen Kontaktflächen beispielsweise mit Gold (Au) oder einer Goldlegierung oder mit Silber (Ag) oder mit einer Silberlegierung oder mit einem anderen geeigneten Material beschichtet sein.

In weiterer vorteilhafter Ausgestaltung des Leistungshalbleiterbauteils kann die externe thermische Kontaktfläche der zweiten Metallschicht des AMB-Substrats so ausgeführt sein, dass die externe thermische Kontaktfläche mittels eines Lötvorgangs oder mittels eines Sintervorgangs oder mittels eines Klebevorgangs mit dem Kühlelement kontaktierbar ist. Dies kann beispielsweise durch eine geeignete Beschichtung der externen thermischen Kontaktfläche umgesetzt werden. So kann die externe thermische Kontaktfläche beispielsweise mit Gold (Au) oder einer Goldlegierung oder mit Silber (Ag) oder mit einer Silberlegierung oder mit einem anderen geeigneten Material beschichtet sein.

In vorteilhafter Ausgestaltung des Verfahrens können die Sintervorgänge zeitgleich ausgeführt werden. Dadurch können Arbeitsschritte eingespart werden.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Draufsicht auf ein erstes Ausführungsbeispiel eines erfindungsgemäßen Leistungshalbleiterbauteils.
Fig. 2 zeigt eine schematische Schnittdarstellung des erfindungsgemäßen Leistungshalbleiterbauteils aus Fig. 1.
Fig. 3 zeigt eine schematische Draufsicht auf ein zweites Ausführungsbeispiel eines erfindungsgemäßen Leistungshalbleiterbauteils.
Fig. 4 zeigt eine schematische Schnittdarstellung eines ersten Ausführungsbeispiel eines erfindungsgemäßen Hochleistungsmoduls, welches mehrere erfindungsgemäße Leistungshalbleiterbauteile aus Fig. 1 und 2 umfasst.
Fig. 5 zeigt eine schematische Draufsicht auf ein drittes Ausführungsbeispiel eines erfindungsgemäßen Leistungshalbleiterbauteils.
Fig. 6 zeigt eine schematische Schnittdarstellung des erfindungsgemäßen Leistungshalbleiterbauteils aus Fig. 5.
Fig. 7 zeigt eine schematische Schnittdarstellung eines zweiten Ausführungsbeispiel eines erfindungsgemäßen Hochleistungsmoduls, welches mehrere erfindungsgemäße Leistungshalbleiterbauteile aus Fig. 5 und 6 umfasst.
Fig. 8 bis 10 zeigen jeweils eine Schnittdarstellung von verschiedenen Ausführungsformen einer Isolationsrippe des erfindungsgemäßen Leistungshalbleiterbauteils aus Fig. 5 und 6.
Fig. 11 zeigt ein Ablaufdiagramm eines Ausführungsbeispiels eines erfindungsgemäßen Verfahrens zur Herstellung eines Leistungshalbleiterbauteils.

### Ausführungsformen der Erfindung

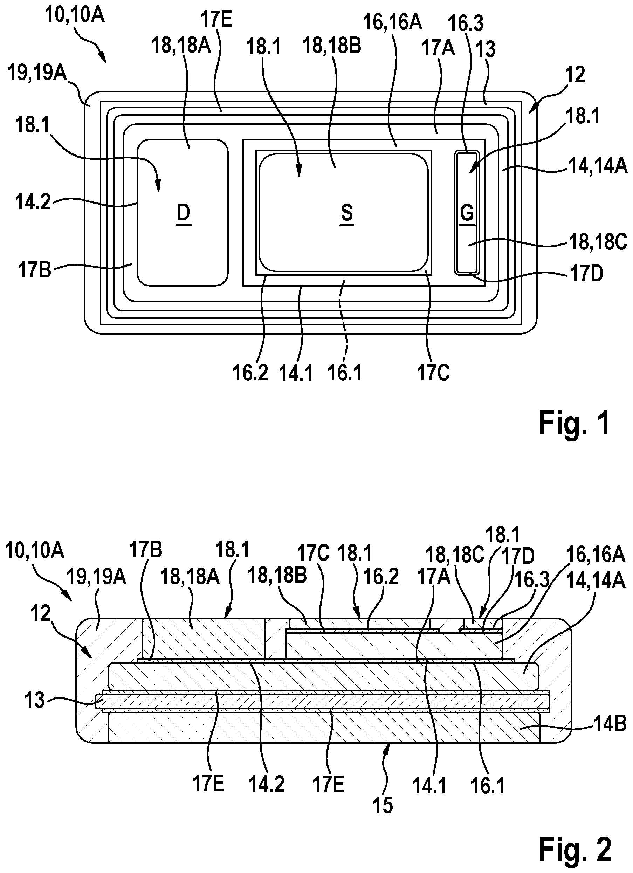

Wie aus Fig. 1 bis 7 ersichtlich ist, umfassen die dargestellten Ausführungsbeispiele eines erfindungsgemäßen Leistungshalbleiterbauteils 10, 10A, 10B, 10C für ein Hochleistungsmodul 1, 1A, 1B jeweils ein AMB-Substrat 12, welches eine zwischen zwei Metallschichten 14 angeordnete Keramikschicht 13 umfasst, einen Halbleiterchip 16, 16A, 16B und mindestens zwei Kontaktelemente 18, welche jeweils mit einem Anschluss 16.1, 16.2, 16.3 des Halbleiterchips 16, 16A, 16B elektrisch verbunden sind. Hierbei ist ein dem AMB-Substrat 12 zugewandter erster Anschluss 16.1 des Halbleiterchips 16, 16A, 16B über eine erste Sinterschicht 17A mit einem vorgegebenen ersten Kontaktbereich 14.1 einer ersten Metallschicht 14A der beiden Metallschichten 14 verbunden. Ein erstes Kontaktelement 18A ist über eine zweite Sinterschicht 17B mit einem zweiten Kontaktbereich 14.2 der ersten Metallschicht 14A verbunden, welcher neben dem ersten Kontaktbereich 14.1 angeordnet und elektrisch mit dem ersten Kontaktbereich 14.1 verbunden ist. Mindestens ein von dem AMB-Substrat 12 abgewandter weiterer Anschluss 16.2, 16.3 des Halbleiterchips 16, 16A, 16B ist über mindestens eine weitere Sinterschicht 17C, 17D direkt mit mindestens einem weiteren Kontaktelement 18B, 18C verbunden, wobei externe Kontaktflächen 18.1 der mindestens zwei Kontaktelemente 18 in einer gemeinsamen Ebene angeordnet und jeweils von oben in Richtung des AMB-Substrats 12 kontaktierbar sind.

In den dargestellten Ausführungsbeispielen ist das Leistungshalbleiterbauteil 10, 10A, 10B, 10C jeweils als MOSFET-Bauteil ausgeführt, bei dem das AMB-Substrat 12 eine Si3N4-Keramik als Keramikschicht 13 aufweist, welche zwischen zwei Metallschichten 14 aus Kupfer angeordnet und über Hartlotschichten 17E mit diesen verbunden ist. Alternativ können die beiden Metallschichten 14 über Sinterschichten mit der Keramikschicht 13 verbunden werden.

Wie aus Fig. 1 bis 7 weiter ersichtlich ist, bildet der erste Anschluss 16.1 des Halbleiterchips 16, 16A, 16B mit dem ersten Kontaktelement 18A einen Drainanschluss D des als MOSFET-Bauteil ausgeführten Leistungshalbleiterbauteils 10, 10A, 10B, 10C. Ein zweiter Anschluss 16.2 des Halbleiterchips 16, 16A, 16B bildet mit einem zweiten Kontaktelement 18B einen Sourceanschluss S des als MOSFET-Bauteil ausgeführten Leistungshalbleiterbauteils 10, 10A, 10B, 10C. Hierbei ist das zweite Kontaktelement 18B mittels einer dritten Sinterschicht 17C mit dem zweiten Anschluss 16.2 des Halbleiterchips 16, 16A, 16B verbunden. Ein dritter Anschluss 16.3 des Halbleiterchips 16, 16A, 16B bildet mit einem dritten Kontaktelement 18C einen Gateanschluss G des als MOSFET-Bauteil ausgeführten Leistungshalbleiterbauteils 10, 10A, 10B, 10C aus. Hierbei ist das dritte Kontaktelement 18C mittels einer vierten Sinterschicht 17D mit dem dritten Anschluss 16.3 des Halbleiterchips 16, 16A, 16B verbunden.

Wie aus Fig. 1, 2 und 4 weiter ersichtlich ist, ist bei dem dargestellten ersten Ausführungsbeispiel des Leistungshalbleiterbauteils 10A das zweite Kontaktelement 18B bzw. der Sourceanschluss S zwischen dem ersten Kontaktelement 18A bzw. dem Drainanschluss D und dem dritten Kontaktelement 18C bzw. dem Gateanschluss G angeordnet.

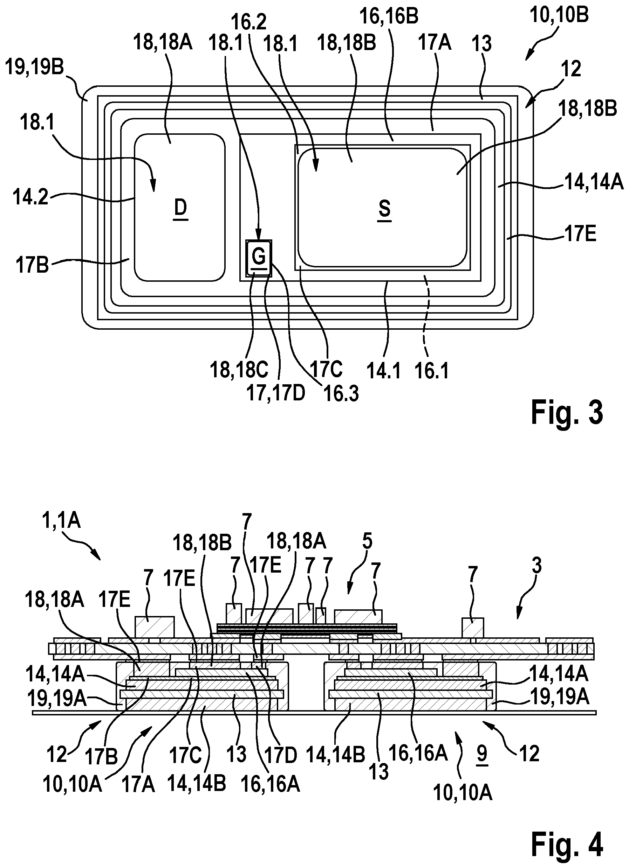

Wie aus Fig. 3 und 5 bis 7 weiter ersichtlich ist, ist bei dem dargestellten zweiten Ausführungsbeispiel des Leistungshalbleiterbauteils 10B und dem dargestellten dritten Ausführungsbeispiel des Leistungshalbleiterbauteils 10C das dritte Kontaktelement 18C bzw. der Gateanschluss G zwischen dem ersten Kontaktelement 18A bzw. dem Drainanschluss D und dem zweiten Kontaktelement 18B bzw. dem Sourceanschluss S angeordnet.

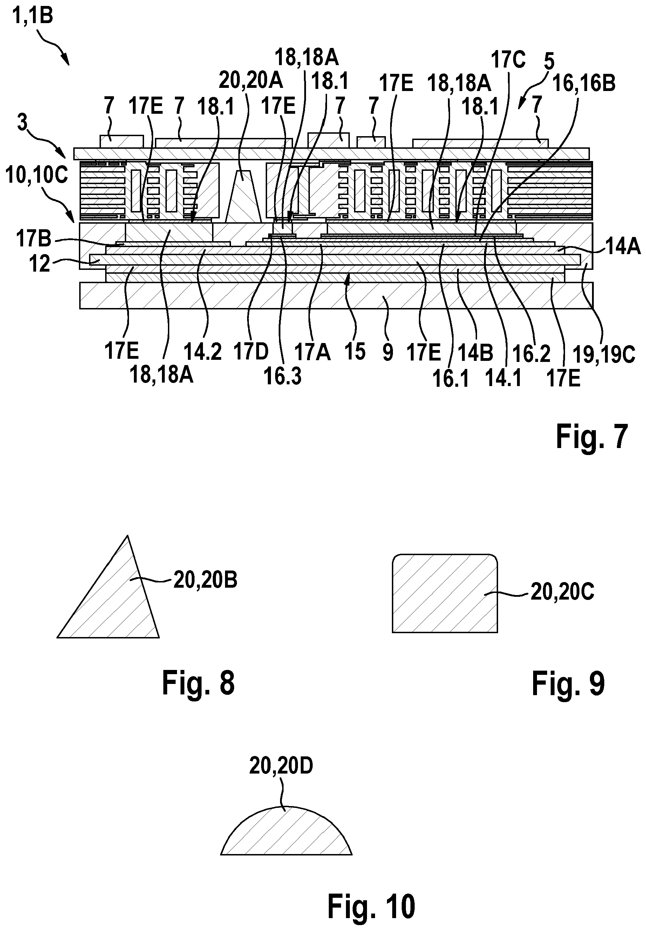

Wie aus Fig. 1 bis 7 weiter ersichtlich ist, bildet eine zweite Metallschicht 14B der beiden Metallschichten 14 des AMB-Substrats 12 eine externe thermische Kontaktfläche 15 aus, welche mit einem Kühlelement 9 verbindbar ist, wie insbesondere aus Fig. 4 und 7 ersichtlich ist. Zudem weist Leistungshalbleiterbauteil 10, 10A, 10B, 10C eine Umhüllung 19, 19A, 19B, 19C aus einem elektrisch isolierenden Material auf, welche das Leistungshalbleiterbauteil 10, 10A, 10B, 10C zumindest teilweise umhüllt. Hierbei lässt die Umhüllung 19, 19A, 19B, 19C zumindest die externen Kontaktflächen 18.1 der drei Kontaktelemente 18A, 18B, 18C und die externe thermische Kontaktfläche 15 der zweiten Metallschicht 14B des AMB-Substrats 12 frei. Hierbei lässt die Umhüllung 19A des ersten Ausführungsbeispiels des Leistungshalbleiterbauteils 10A nur die externen Kontaktflächen 18.1 der drei Kontaktelemente 18A, 18B, 18C und die externe thermische Kontaktfläche 15 der zweiten Metallschicht 14B des AMB-Substrats 12 frei. Die Umhüllung 19B des zweiten Ausführungsbeispiels des Leistungshalbleiterbauteils 10B und die Umhüllung 19C des dritten Ausführungsbeispiels des Leistungshalbleiterbauteils 10C lassen neben den externen Kontaktflächen 18.1 der drei Kontaktelemente 18A, 18B, 18C und der externen thermischen Kontaktfläche 15 der zweiten Metallschicht 14B des AMB-Substrats 12 auch ungefähr die Hälfte der zweiten Metallschicht 14B des AMB-Substrats 12 frei.

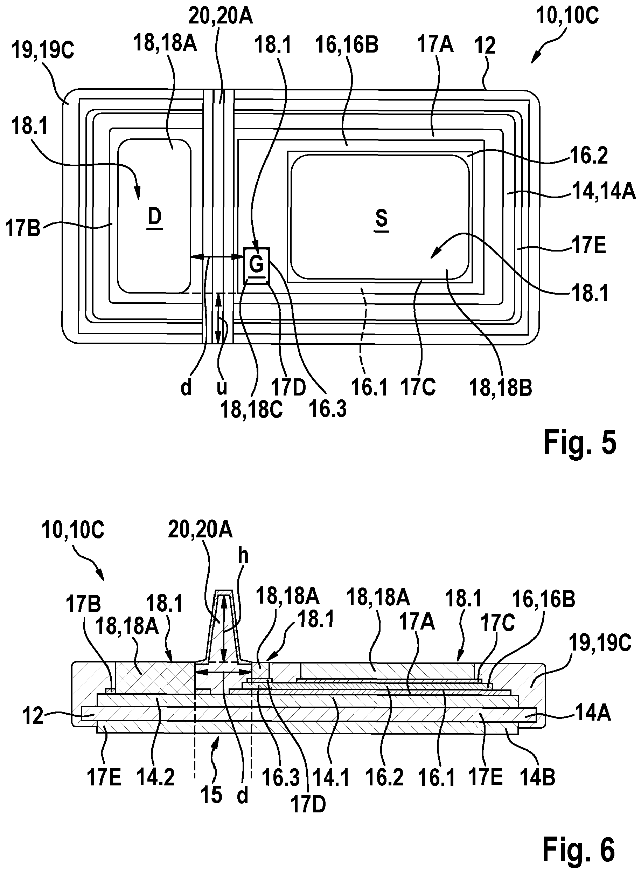

Wie aus Fig. 5 bis 10 weiter ersichtlich ist, umfasst die Umhüllung 19C des dritten Ausführungsbeispiels des Leistungshalbleiterbauteils zusätzlich eine überstehende Isolationsrippe 20, 20A, 20B, 20C, 20D, welche zwischen dem ersten Kontaktelement 18A und dem mindestens einen weiteren Kontaktelement 18B, 18C angeordnet ist und eine vorgegebene Höhe h, eine vorgegebene Breite d und einen vorgegebenen Überstand u zu den mindestens zwei Kontaktelementen 18 aufweist. Im dargestellten dritten Ausführungsbeispiel des Leistungshalbleiterbauteils 10C ist die Isolationsrippe 20, 20A, 20B, 20C, 20D zwischen dem ersten Kontaktelement 18A bzw. dem Drainanschluss D und dem dritten Kontaktelement 18C bzw. dem Gateanschluss G angeordnet. Bei dem in Fig. 1, 2 und 3 dargestellten ersten Ausführungsbeispiel des Leistungshalbleiterbauteils 10A, wäre die Isolationsrippe 20, 20A, 20B, 20C, 20D zwischen dem ersten Kontaktelement 18A bzw. dem Drainanschluss D und dem zweiten Kontaktelement 18B bzw. dem Sourceanschluss G angeordnet. Wie aus Fig. 5 bis 7 weiter ersichtlich ist, weist ein erstes Ausführungsbeispiel der Isolationsrippe 20A einen trapezförmigen Querschnitt auf. Fig. 8 zeigt ein zweites Ausführungsbeispiel der Isolationsrippe 20B mit einem dreieckigen Querschnitt. Fig. 9 zeigt ein drittes Ausführungsbeispiel der Isolationsrippe 20C mit einem rechteckigen Querschnitt. Fig. 10 zeigt ein viertes Ausführungsbeispiel der Isolationsrippe 20D mit einem runden Querschnitt.

Bei den dargestellten Ausführungsbeispielen der Leistungshalbleiterbauteile 10, 10A, 10B, 10C sind die Kontaktelemente 18A, 18B, 18C jeweils als beschichtete Metallplättchen ausgeführt, so dass die externen Kontaktflächen 18.1 mittels eines Lötvorgangs oder mittels eines Sintervorgangs oder mittels eines Bondvorgangs kontaktierbar sind. Hierbei ist die Dicke der Metallplättchen so gewählt, dass die ersten Kontaktflächen 18.1 der drei Kontaktelemente 18A, 18B, 18C in der gemeinsamen horizontalen Ebene angeordnet und von oben kontaktierbar sind. Auch die externe thermische Kontaktfläche 15 der zweiten Metallschicht 14B des AMB-Substrats 12 weist eine Beschichtung auf, so dass die externe thermische Kontaktfläche 15 mittels eines Lötvorgangs oder mittels eines Sintervorgangs oder mittels eines Klebevorgangs mit dem Kühlelement 9 kontaktierbar ist. Das Kühlelement 9 kann beispielsweise als Fluidkühler oder als Kühlkörper ausgeführt werden.

Wie aus Fig. 4 und 7 weiter ersichtlich ist, umfassen die dargestellten Ausführungsbeispiele eines erfindungsgemäßen Hochleistungsmoduls 1, 1A, 1B jeweils mindestens ein Leistungshalbleiterbauteil 10, 10A, 10B, 10C.

Wie aus Fig. 4 weiter ersichtlich ist, umfasst das dargestellte erste Ausführungsbeispiel des Hochleistungsmoduls 1A mehrere erste Ausführungsbeispiele des Leistungshalbleiterbauteils 10A, von denen im dargestellten Ausschnitt zwei Leistungshalbleiterbauteile 10A sichtbar sind, einen mehrlagigen Schaltungsträger 3, auf welchem ein Logikmodul 5 und mehrere elektrische Bauteilen 7, wie beispielsweise Spannungsteiler aus ohmschen Widerständen oder Shunt-Widerstände angeordnet sind. Zudem weist der Schaltungsträger 3 zur Verbindung der einzelnen elektrischen Bauteile 7 und zur Kontaktierung der Leistungshalbleiterbauteile 10A entsprechende nicht näher bezeichnete Leiterbahnen, Durchkontaktierungen und Kontaktflächen auf. Auf dem Logikmodul 5 sind ebenfalls mehrere elektrische Bauteile 7 angeordnet, welche beispielsweise eine Steuerschaltung zur Ansteuerung der Leistungshalbleiterbauteile 10A ausbilden. Auch das Logikmodul 5 weist zur Verbindung der einzelnen elektrischen Bauteile und zur Kontaktierung des Logikmoduls 5 entsprechende nicht näher bezeichnete

Leiterbahnen, Durchkontaktierungen und Kontaktflächen auf. Im dargestellten ersten Ausführungsbeispiel des Hochleistungsmoduls 1A sind die externen Kontaktflächen 18.1 der drei Kontaktelemente 18A, 18B, 18C jeweils über eine Hartlotverbindung 17E mit zugeordneten Kontaktflächen des Schaltungsträgers 3 verbunden und elektrisch kontaktiert.

Wie aus Fig. 7 weiter ersichtlich ist, umfasst das dargestellte zweite Ausführungsbeispiel des Hochleistungsmoduls 1B mehrere dritte Ausführungsbeispiele des Leistungshalbleiterbauteils 10C, von denen im dargestellten Ausschnitt ein Leistungshalbleiterbauteil 10C sichtbar ist, einen mehrlagigen Schaltungsträger 3, auf welchem ein Logikmodul 5 und mehrere nicht sichtbare elektrische Bauteile, wie beispielsweise Spannungsteiler aus ohmschen Widerständen oder Shunt-Widerstände angeordnet sind. Zudem weist der Schaltungsträger 3 zur Verbindung der einzelnen elektrischen Bauteile und zur Kontaktierung der Leistungshalbleiterbauteile 10C entsprechende nicht näher bezeichnete Leiterbahnen, Durchkontaktierungen und Kontaktflächen auf. Zudem weist der Schaltungsträger 3 eine Aussparung auf, welche die Isolationsrippe 20, 20A, 20B, 20C, 20D des Leistungshalbleiterbauteils 10C aufnimmt. Auf dem Logikmodul 5 sind ebenfalls mehrere elektrische Bauteile 7 angeordnet, welche beispielsweise eine Steuerschaltung zur Ansteuerung der Leistungshalbleiterbauteile 10C ausbilden. Auch das Logikmodul 5 weist zur Verbindung der einzelnen elektrischen Bauteile und zur Kontaktierung des Logikmoduls 5 entsprechende nicht näher bezeichnete Leiterbahnen, Durchkontaktierungen und Kontaktflächen auf. Im dargestellten zweiten Ausführungsbeispiel des Hochleistungsmoduls 1C sind die externen Kontaktflächen 18.1 der drei Kontaktelemente 18A, 18B, 18C jeweils über eine Hartlotverbindung 17E mit zugeordneten Kontaktflächen des Schaltungsträgers 3 verbunden und elektrisch kontaktiert.

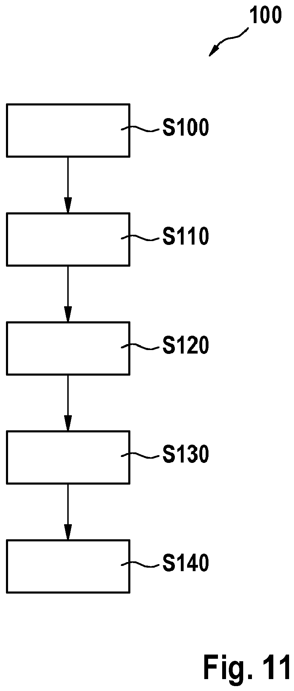

Wie aus Fig. 11 weiter ersichtlich ist, umfasst das dargestellte Ausführungsbeispiel eines erfindungsgemäßen Verfahrens 100 zur Herstellung eines oben beschriebenen Leistungshalbleiterbauteils 10 einen Schritt S100, welcher ein AMB-Substrat 12, bei welchem eine Keramikschicht 13 flächig mit zwei Metallschichten 14 verbunden ist, ein Halbleiterchips 16 und mindestens zwei Kontaktelemente 18 bereitgestellt werden. Im Schritt S110 wird der Halbleiterchip 16 mittels eines ersten Sintervorgangs so mit dem AMB-Substrat 12 verbunden, dass ein dem AMB-Substrat 12 zugewandter erster Anschluss 16.1 des Halbleiterchips 16 über eine erste Sinterschicht 17A mit einem vorgegebenen ersten Kontaktbereich 14.1 einer ersten Metallschicht 14A der beiden Metallschichten 14 des AMB-Substrats 12 verbunden ist. Im Schritt S120 wird ein erstes Kontaktelement 18A der mindestens zwei Kontaktelemente 18 angeordnet und mit einem vorgegebenen zweiten Kontaktbereich 14.2 der ersten Kupferschicht 14A, welcher neben dem ersten Kontaktbereich 14.1 angeordnet und elektrisch mit dem ersten Kontaktbereich 14.1 verbunden ist, mittels eines zweiten Sintervorgangs verbunden, so dass das erste Kontaktelement 18A über eine zweite Sinterschicht 17B mit dem zweiten Kontaktbereich 14.2 verbunden ist. Im Schritt S130 wird mindestens ein weiteres Kontaktelement 18B, 18C der mindestens zwei Kontaktelemente 18 angeordnet und mit mindestens einem von dem AMB-Substrat 12 abgewandten weiteren Anschluss 16.2, 16.3 des Halbleiterchips 16 mittels mindestens eines weiteren Sintervorgangs verbunden, so dass der mindestens eine weitere Anschluss 16.2, 16.3 über mindestens eine weitere Sinterschicht 17C, 17D direkt mit dem mindestens einen weiteren Kontaktelement 18B, 18C verbunden ist. Hierbei werden die mindestens zwei Kontaktelemente 18 so ausgeführt und angeordnet, dass externe Kontaktflächen 18.1 der mindestens zwei Kontaktelemente 18 in einer gemeinsamen Ebene angeordnet und jeweils von oben in Richtung des AMB-Substrats 12 kontaktierbar sind.

Zudem wird im dargestellten Ausführungsbeispiel des Verfahrens 100 das Leistungshalbleiterbauteil 10 im Schritt S140 in einem Spritz-Gieß-Vorgang zumindest teilweise mit einer Umhüllung 19, 19A, 19B, 19C umhüllt.

Hierbei wird zur Herstellung des ersten Ausführungsbeispiels des Leistungshalbleiterbauteils 10A die Umhüllung 19A im Schritt S140 so ausgeführt, dass nur die externen Kontaktflächen 18.1 der drei Kontaktelemente 18A, 18B, 18C und die an der zweiten Metallschicht 14B der beiden Metallschichten 14 des AMB-Substrats 12 ausgebildete externe thermische Kontaktfläche 15 freigelassen sind.

Zur Herstellung des zweiten Ausführungsbeispiels des Leistungshalbleiterbauteils 10B wird die Umhüllung 19B im Schritt S140 so ausgeführt, dass zusätzlich zu den externen Kontaktflächen 18.1 der drei Kontaktelemente 18A, 18B, 18C und der an der zweiten Metallschicht 14B der beiden Metallschichten 14 des AMB-Substrats 12 ausgebildeten externen thermischen Kontaktfläche 15 die zweite Metallschicht 14B freigelassen ist.

Zur Herstellung des dritten Ausführungsbeispiels des Leistungshalbleiterbauteils 10C wird die Umhüllung 19C mit einer überstehenden Isolationsrippe 20, 20A, 20B, 20C, 20D ausgeführt, welche zwischen dem ersten Kontaktelement 18A und dem mindestens einen weiteren Kontaktelement 18B, 18C ausgebildet wird und eine vorgegebene Höhe h, eine vorgegebene Breite d und einen vorgegebenen Überstand u zu den mindestens zwei Kontaktelementen 18 aufweist.

Im dargestellten Ausführungsbeispiel des Verfahrens 100 werden die Sintervorgänge zeitgleich ausgeführt.

## Patentansprüche

1. Leistungshalbleiterbauteil (10) für ein Hochleistungsmodul (1), mit einem AMB-Substrat (12), welches eine zwischen zwei Metallschichten (14) angeordnete Keramikschicht (13) umfasst, einem Halbleiterchip (16) und mindestens zwei Kontaktelementen (18), welche jeweils mit einem Anschluss (16.1, 16.2, 16.3) des Halbleiterchips (16) elektrisch verbunden sind, wobei ein dem AMB-Substrat (12) zugewandter erster Anschluss (16.1) des Halbleiterchips (16) über eine erste Sinterschicht (17A) mit einem vorgegebenen ersten Kontaktbereich (14.1) einer ersten Metallschicht (14A) der beiden Metallschichten (14) verbunden ist, wobei ein erstes Kontaktelement (18A) über eine zweite Sinterschicht (17B) mit einem zweiten Kontaktbereich (14.2) der ersten Metallschicht (14A) verbunden ist, welcher neben dem ersten Kontaktbereich (14.1) angeordnet und elektrisch mit dem ersten Kontaktbereich (14.1) verbunden ist, wobei mindestens ein von dem AMB-Substrat (12) abgewandter weiterer Anschluss (16.2, 16.3) des Halbleiterchips (16) über mindestens eine weitere Sinterschicht (17C, 17D) direkt mit mindestens einem weiteren Kontaktelement (18B, 18C) verbunden ist, wobei externe Kontaktflächen (18.1) der mindestens zwei Kontaktelemente (18) in einer gemeinsamen Ebene angeordnet und jeweils von oben in Richtung des AMB-Substrats (12) kontaktierbar sind.

2. Leistungshalbleiterbauteil (10) nach Anspruch 1, **dadurch gekennzeichnet, dass** eine zweite Metallschicht (14B) der beiden Metallschichten (14) des AMB-Substrats (12) eine externe thermische Kontaktfläche (15) ausbildet, welche mit einem Kühlelement verbindbar ist.

3. Leistungshalbleiterbauteil (10) nach Anspruch 1 oder 2, **gekennzeichnet durch** eine Umhüllung (19) aus einem elektrisch isolierenden Material, welche das Leistungshalbleiterbauteil (10) zumindest teilweise umhüllt.

4. Leistungshalbleiterbauteil (10) nach Anspruch 3, **dadurch gekennzeichnet, dass** die Umhüllung (19) zumindest die externen Kontaktflächen (18.1) der mindestens zwei Kontaktelemente (18) und die externe thermische Kontaktfläche (15) der zweiten Metallschicht (14B) des AMB-Substrats (12) freilässt.

5. Leistungshalbleiterbauteil (10) nach Anspruch 3 oder 4, **dadurch gekennzeichnet, dass** die Umhüllung (19) eine überstehende Isolationsrippe (20) umfasst, welche zwischen dem ersten Kontaktelement (18A) und dem mindestens einen weiteren Kontaktelement (18B, 18C) angeordnet ist und eine vorgegebene Höhe (h), eine vorgegebene Breite (d) und einen vorgegebenen Überstand (u) zu den mindestens zwei Kontaktelementen (18) aufweist.

6. Leistungshalbleiterbauteil (10) nach Anspruch 5, **dadurch gekennzeichnet, dass** die Isolationsrippe (20) einen dreieckigen oder einen runden oder einen trapezförmigen oder rechteckigen Querschnitt aufweist.

7. Leistungshalbleiterbauteil (10) nach einem der Ansprüche 1 bis 6, **dadurch gekennzeichnet, dass** die externen Kontaktflächen (18.1) der mindestens zwei Kontaktelemente (18) so ausgeführt sind, dass die externen Kontaktflächen (18.1) mittels eines Lötvorgangs oder mittels eines Sintervorgangs oder mittels eines Bondvorgangs kontaktierbar sind.

8. Leistungshalbleiterbauteil (10) nach einem der Ansprüche 2 bis 7, **dadurch gekennzeichnet, dass** die externe thermische Kontaktfläche (15) der zweiten Metallschicht (14B) so ausgeführt ist, dass die externe thermische Kontaktfläche (15) mittels eines Lötvorgangs oder mittels eines Sintervorgangs oder mittels eines Klebevorgangs mit dem Kühlelement (9) kontaktierbar ist.

9. Hochleistungsmodul (1) mit mindestens einem Leistungshalbleiterbauteil (10), welches nach einem der Ansprüche 1 bis 8 ausgeführt ist.

10. Verfahren (100) zur Herstellung eines Leistungshalbleiterbauteils (10) mit den Schritten: Bereitstellen eines AMB-Substrats (12), bei welchem eine Keramikschicht (13) flächig mit zwei Metallschichten (14) verbunden ist, eines Halbleiterchips (16) und von mindestens zwei Kontaktelementen (18), Verbinden des Halbleiterchips (16) mit dem AMB-Substrat (12) mittels eines ersten Sintervorgangs, so dass ein dem AMB-Substrat (12) zugewandter erster Anschluss (16.1) des Halbleiterchips (16) über eine erste Sinterschicht (17A) mit einem vorgegebenen ersten Kontaktbereich (14.1) einer ersten Metallschicht (14A) der beiden Metallschichten (14) verbunden ist, Anordnen und Verbinden eines ersten Kontaktelements (18A) der mindestens zwei Kontaktelemente (18) mit einem vorgegebenen zweiten Kontaktbereich (14.2) der ersten Kupferschicht (14A), welcher neben dem ersten Kontaktbereich (14.1) angeordnet und elektrisch mit dem ersten Kontaktbereich (14.1) verbunden ist, mittels eines zweiten Sintervorgangs, so dass das erste Kontaktelement (18A) über eine zweite Sinterschicht (17B) mit dem zweiten Kontaktbereich (14.2) verbunden ist, Anordnen und Verbinden von mindestens einem weiteren Kontaktelement (18B, 18C) der mindestens zwei Kontaktelemente (18) mit mindestens einem von dem AMB-Substrat (12) abgewandten weiteren Anschluss (16.2, 16.3) des Halbleiterchips (16) mittels mindestens eines weiteren Sintervorgangs, so dass der mindestens eine weitere Anschluss (16.2, 16.3) über mindestens eine weitere Sinterschicht (17C, 17D) direkt mit dem mindestens einen weiteren Kontaktelement (18B, 18C) verbunden ist, wobei die mindestens zwei Kontaktelemente (18) so ausgeführt und angeordnet werden, dass externe Kontaktflächen (18.1) der mindestens zwei Kontaktelemente (18) in einer gemeinsamen Ebene angeordnet und jeweils von oben in Richtung des AMB-Substrats (12) kontaktierbar sind.

11. Verfahren (100) nach Anspruch 10, **dadurch gekennzeichnet, dass** das Leistungshalbleiterbauteil (10) in einem Spritz-Gieß-Vorgang zumindest teilweise mit einer Umhüllung (19) umhüllt wird.

12. Verfahren (100) nach Anspruch 11, **dadurch gekennzeichnet, dass** die Umhüllung (19) zumindest die externen Kontaktflächen (18.1) der mindestens zwei Kontaktelemente (18) und eine an einer zweiten Metallschicht (14B) der beiden Metallschichten (14) des AMB-Substrats (12) ausgebildete externe thermische Kontaktfläche (15) freilässt.

13. Verfahren (100) nach Anspruch 11 oder 12, **dadurch gekennzeichnet, dass** die Umhüllung (19) eine überstehende Isolationsrippe (20) umfasst, welche zwischen dem ersten Kontaktelement (18A) und dem mindestens einen weiteren Kontaktelement (18B, 18C) ausgebildet wird und eine vorgegebene Höhe (h), eine vorgegebene Breite (d) und einen vorgegebenen Überstand (u) zu den mindestens zwei Kontaktelementen (18) aufweist.

14. Verfahren (100) nach einem der Ansprüche 10 bis 13, **dadurch gekennzeichnet, dass** die Sintervorgänge zeitgleich ausgeführt werden.
